# EUROPEAN PATENT APPLICATION

(11) **EP 4 524 297 A1**
(43) Date of publication of application: **19.03.2025**
(21) Application number: 24817821.2
(22) Date of filing: 25.04.2024
(51) Int. Cl.: C30B 23/06, C30B 29/36

(54) **GROWTH DEVICE AND GROWTH METHOD FOR SILICON CARBIDE SINGLE CRYSTAL**

(30) Priority: 05.06.2023 CN 202310651590
(71) Applicant: Suzhou Uking Semiconductor Technology Co., Ltd., Suzhou, Jiangsu 215300 (CN)
(72) Inventor: CHEN, Jianming, Suzhou, Jiangsu 215300 (CN); ZHOU, Yuanhui, Suzhou, Jiangsu 215300 (CN); ZHAO, Wenchao, Suzhou, Jiangsu 215300 (CN); GENG, Andong, Suzhou, Jiangsu 215300 (CN); YANG, Hongyu, Suzhou, Jiangsu 215300 (CN)
(74) Representative: Lapienis, Juozas
(86) International application number: PCT/CN2024/089846
(87) International publication number: WO 2024/250864

(57) **Abstract**

The present application belongs to the technical field of growth of silicon carbide single crystals, and specifically relates to a growth device of a silicon carbide single crystal and a crystal growth method. The crystal growth device includes a crucible portion and a heating portion, wherein the crucible portion includes a first crucible portion and a second crucible portion which are coaxially provided from top to bottom, a seed crystal accommodation portion is provided in the middle of a top of the first crucible portion, the second crucible portion is provided with a cavity which is a raw material accommodation portion, an outer diameter of the first crucible portion is smaller than that of the second crucible portion, and a concavity recessed towards the first crucible portion is provided in the middle of a bottom of the second crucible portion; the heating portion includes a first heating portion, a second heating portion and a third heating portion, wherein the first heating portion is circumferentially provided in the concavity, the second heating portion is circumferentially provided outside the second crucible portion, the third heating portion is circumferentially provided outside the first crucible portion, and an inner diameter of the third heating portion is smaller than the outer diameter of the second crucible portion. The crystal growth device of the present application can reduce defects such as inclusions, dislocation densities, and micropipes in the silicon carbide single crystal, and improve internal quality of the crystal.

## Description

### CROSS-REFERENCE TO RELATED APPLICATION

The present application claims the priority to the Chinese patent application with the filing No. 202310651590.3 filed on June 5, 2023 with the Chinese Patent Office, and entitled "GROWTH DEVICE OF SILICON CARBIDE SINGLE CRYSTAL AND GROWTH METHOD", the contents of which are incorporated herein by reference in entirety.

### TECHNICAL FIELD

The present application belongs to the technical field of growth of silicon carbide crystals, and specifically relates to a growth device of a silicon carbide single crystal and a crystal growth method.

### BACKGROUND ART

The physical vapor transport (PVT) method is currently a main method of industrial growth of a silicon carbide crystal, which specifically includes transporting gas generated from sublimation and decomposition of silicon carbide raw materials to surfaces of seed crystals to recrystallize, so as to obtain a silicon carbide single crystal with a large area.

However, at high temperatures, silicon element and silicon-rich radical are easier to escape from the raw material, and cause carbonization of the raw material. Severely carbonized raw material will generate carbon dust, which will be deposited on a crystal growth interface along with gas flow to form defects of inclusions. The defects of inclusions will further grow into a larger range of defects such as screw dislocations, stacking faults and micropipes, which severely affect crystal quality of silicon carbide. Especially when growing a large-size crystal, a radial temperature gradient of the raw material increases as a diameter of a crucible increases, and the raw material in a high-temperature region tends to have a severe phenomenon of carbonization, thus causing further increase in the number and volume of inclusions of the crystal. In addition, when growing a large-size crystal, it is prone to generation of induced dislocations and like crystal defects due to excessive internal stress of the crystal because of a too large temperature gradient of the crystal, and even cause cracks of the crystal in severe cases.

### SUMMARY

The present application aims at providing a growth device of a silicon carbide single crystal and a crystal growth method, so as to overcome defects of inclusions, screw dislocations, stacking faults and micropipes existing in silicon carbide single crystals manufactured by the PVT method, and the defects of generation of induced dislocations and even crystal cracks in the silicon carbide single crystals due to excessive internal stress. The crystal growth device and the crystal growth method effectively reduce the defects such as inclusions, screw dislocations, stacking faults, and micropipes in the silicon carbide single crystals, and reduce the internal stress.

In order to achieve the above objective, in the first aspect, the present application provides a growth device of a silicon carbide single crystal, where the device includes a crucible portion and a heating portion:

the crucible portion includes a first crucible portion and a second crucible portion which are coaxially provided from top to bottom, where a seed crystal accommodation portion is provided in the middle of a top of the first crucible portion, the second crucible portion is provided with a cavity, which is a raw material accommodation portion, an outer diameter of the first crucible portion is smaller than that of the second crucible portion, and a concavity recessed towards the first crucible portion is provided in the middle of a bottom of the second crucible portion;

the heating portion is a graphite heating portion, and the heating portion includes a first heating portion, a second heating portion and a third heating portion; and

the first heating portion is provided in the concavity in a circumferential direction of the concavity, the second heating portion is provided outside the second crucible portion in a circumferential direction of the second crucible portion, the third heating portion is provided outside the first crucible portion in a circumferential direction of the first crucible portion, and an inner diameter of the third heating portion is smaller than the outer diameter of the second crucible portion.

Optionally, an arc-shaped protrusion is provided in the middle of a bottom of the concavity, and the arc-shaped protrusion is provided on a side facing the first crucible portion.

Optionally, a value range of a ratio of the outer diameter of the second crucible portion to the outer diameter of the first crucible portion is 1.05-4.0, a value range of a ratio of the inner diameter of the second heating portion to the inner diameter of the third heating portion is 1.05-4.0, and a value range of a ratio of the diameter of the seed crystal accommodation portion to the inner diameter of the third heating portion is 0.26-0.92.

Optionally, relative to a raw-material loading reference plane of the second crucible portion, a position of an upper end of the second heating portion is 10 mm-50 mm higher than a position of the raw-material loading reference plane; and a position of a lower end of the second heating portion is 20 mm-100 mm lower than a position of a lower end of the second crucible portion.

Optionally, a vertical distance between a lower end of the third heating portion and the upper end of the second heating portion is 15 mm-60 mm; and
a position of an upper end of the third heating portion is higher than a position of an upper end of a seed crystal accommodation space of the seed crystal accommodation portion, an upper furnace lid is provided above the first crucible portion, the upper end of the third heating portion is connected to a third electrode, and the third electrode is movably connected to the upper furnace lid.

Optionally, a lower furnace lid is provided below the second crucible portion, a lower end of the first heating portion is connected to a first electrode, and the first electrode is movably connected to the lower furnace lid; and
the concavity is connected to a support column in the middle of the bottom thereof, the support column is connected to a side facing back to the first crucible portion, the first heating portion is provided to be spaced apart from the support column, the bottom of the concavity and a side surface of the concavity respectively, at an interval of 15 mm-40 mm.

Optionally, the seed crystal accommodation portion has a circular cross section.

Optionally, the first crucible portion and the second crucible portion are cylindrical.

Optionally, when a cross section of the concavity is circular, a ratio of a diameter of the arc-shaped protrusion to a diameter of a bottom of the concavity is 0.5-1.0, and a ratio of a height of the arc-shaped protrusion to a distance from a side of the bottom of the concavity facing the first crucible portion to the raw-material loading reference plane is 0.15-0.5.

Optionally, a lower end of the support column is connected to a rotary motor and a lifting motor.

Optionally, a thermal insulation layer is provided above the first crucible portion, below the second crucible portion, and around the second heating portion and the third heating portion.

In the second aspect, the present application provides a growth method of a silicon carbide single crystal using the crystal growth device in the first aspect, where powers of the first heating portion, the second heating portion and the third heating portion are P1, P2 and P3 respectively, and the crystal growth method includes steps as follows:
a heating-up step: loading raw materials into a raw material accommodation portion, and mounting and fixing seed crystals in the seed crystal accommodation portion; detecting air tightness in a furnace shell cavity enclosed by an upper furnace lid, a lower furnace lid and a furnace barrel, and then performing a vacuumizing treatment on interior of the furnace shell cavity; and heating by the first heating portion, the second heating portion and the third heating portion, so as to enable a temperature of a top of the first crucible portion to reach 2,100-2,200 °C, where during the heating, relationships between P1, P2 and P3 are as follows: P1 < P3 < P2, P2 > P1 + P3, and P1: P3 = 0.1-0.5;
a crystal growth (crystallization) step: performing first adjustment, second adjustment, third adjustment and fourth adjustment in sequence, where the first adjustment includes adjusting a ratio of P1 to P2, to enable a temperature difference between raw materials at a crucible-side-wall side of the second crucible portion and raw materials at a concavity side to be less than 15 °C; the second adjustment includes adjusting P3, so as to adjust a ratio of P3 to P1+P2 to enable a temperature of an upper surface of the raw materials to be 15 °C-80 °C higher than a temperature of a lower surface of the seed crystals; the third adjustment includes adjusting P3, so as to enable a temperature difference between seed crystals at the edge and the seed crystals in the middle to be less than 20 °C; the fourth adjustment includes adjusting a pressure in the furnace shell cavity to be 50 Pa-1,500 Pa, so that radicals volatized from the raw materials crystallize and grow on a surface of the seed crystals, and an upper part of raw materials with a preset thickness of the raw materials do not react; and
a crystal growth finishing step: performing fifth adjustment, sixth adjustment and seventh adjustment in sequence, where the fifth adjustment includes increasing the pressure in the furnace shell cavity to 2,500 Pa-20,000 Pa; the sixth adjustment includes adjusting P1+P2 downwards to reduce an axial temperature gradient of the silicon carbide single crystal, so that the axial temperature gradient between a lower surface of the silicon carbide single crystal and an upper surface of the silicon carbide single crystal is ≤ 20 °C/cm; and the seventh adjustment includes lowering P1, P2 and P3 to enable P1 = P2 = P3 = 0, where the sixth adjustment and the seventh adjustment are separated by a preset period, where the preset period is 2 h or above.

Optionally, the vacuumizing treatment includes, in sequence, vacuumizing by a mechanical pump to enable the pressure in the furnace shell cavity to be 0.1 Pa-5 Pa, vacuumizing by a molecular pump to enable the pressure in the furnace shell cavity to be 10⁻²-10⁻⁴ Pa, and heating by the first heating portion, the second heating portion and the third heating portion to enable a temperature of the top of the first crucible portion to reach 750 °C-850 °C.

Optionally, the heating-up step further includes when the temperature of the top of the first crucible portion reaches 900 °C-1,100 °C, and adjusting and maintaining the pressure in the furnace shell cavity to be 10,000-20,000 Pa.

Optionally, eighth adjustment is further included after the fourth adjustment, where the eighth adjustment includes: in the case that the ratio of P1 to P2 is constant, adjusting P1+P2 upwards, so that the temperature difference between the upper surface of the raw materials and the lower surface of the silicon carbide single crystal is increased at a rate of 0.5 °C/h-5.0 °C/h, so that the temperature of the upper surface of the raw materials is 30 °C-100 °C higher than that of the lower surface of the silicon carbide single crystal.

Optionally, ninth adjustment is further included between the third adjustment and the fourth adjustment, where the ninth adjustment includes adjusting a position of the second crucible portion by the lifting motor, so that a temperature of a lower part of the raw materials is higher than a temperature of an upper part of the raw materials, and a temperature difference is controlled to be within 15 °C.

In the present application, by providing the concavity recessed towards the first crucible portion in the middle of the bottom of the second crucible portion, and providing the first heating portion in the concavity in the circumferential direction, during the growth of the silicon carbide single crystal, interior of the raw materials can be heated, so as to avoid formation of a crystallization region in the center. Further, as the highest-temperature point of a graphite heater is located in the vicinity of a central height of the heater, through cooperation of the first heating portion and the second heating portion, during growth of the silicon carbide single crystal, the upper part of raw materials with a preset thickness in the raw materials are enabled to not react.

In the present application, by providing the first heating portion in the concavity in the circumferential direction, through cooperation of the first heating portion in the concavity and the second heating portion outside the second crucible portion, it can be realized that the raw materials at the concavity side and the raw materials at the crucible-side-wall side of the second crucible portion are heated more uniformly, and during the growth of the silicon carbide single crystal, problems of severe carbonization of raw materials, increased carbon dust, local carbon enrichment, carbon collapse, etc. caused by excessive local external temperature due to external heating alone can be avoided, so as to reduce the defects such as inclusions, screw dislocations, stacking faults, and micropipes in the silicon carbide single crystal.

In the present application, by enabling the outer diameter of the first crucible portion to be smaller than the outer diameter of the second crucible portion, and providing the third heating portion outside the first crucible portion, during the growth of the silicon carbide single crystal, the radial temperature gradient of the silicon carbide single crystal formed can be adjusted, so that the defects of generation of induced dislocations and even crystal cracks caused by excessive internal stress are prevented, and besides, temperature of edge of the crystal can be increased, and probability of edge polycrystalline and polytypism can be reduced. Further, the inner diameter of the third heating portion is smaller than the outer diameter of the second crucible portion, so that the heat generated by the third heating portion is closer to a central part of the upper surface of the raw materials, and an outer edge of the raw materials is less heated, thus preventing occurrence of carbonization phenomenon at the edge of the raw materials; meanwhile, as the highest-temperature point of the graphite heater is located in the vicinity of the central height of the heater, heating the edge of the raw materials by the third heating portion and the second heating portion may not form a severe carbonization region, but instead, an unreacted region may be formed.

In the present application, through cooperation of the graphite crucible structure, the second heating portion and the third heating portion, the upper part of raw materials with a preset thickness of raw materials at the edge are enabled to not react, and through cooperation of the first heating portion and the second heating portion, the upper part of raw materials with a preset thickness in the middle portion of the raw materials may be enabled to not form a crystallization region due to local undercooling, while an unreacted region layer may be formed on the surface of the raw materials. During sublimation and recrystallization of the raw materials, the unreacted raw materials, as a filter layer, prevent the carbon dust from entering a crystal growth chamber, thus achieving the purpose of greatly reducing the inclusions. During the growth of the silicon carbide single crystal, the unreacted region layer formed on the surface of the raw materials can be recycled after removal of free carbon and cleaning.

In the growth method of a silicon carbide single crystal provided in the present application, by defining the relationships between the powers of the first heating portion, the second heating portion and the third heating portion in the heating-up step, and by performing the first adjustment, the second adjustment, the third adjustment and the fourth adjustment in sequence in the crystal growth stage, the upper part of raw materials with a preset thickness of the raw materials are enabled to not react, and the unreacted raw materials, as a filter layer, can prevent the carbon dust from entering the crystal growth chamber, so as to reduce the defects such as inclusions, screw dislocations, stacking faults and micropipes in the silicon carbide single crystal, and after the crystal growth is finished, the unreacted raw materials can be recycled after removal of free carbon and cleaning.

### BRIEF DESCRIPTION OF DRAWINGS

In order to more clearly illustrate technical solutions of embodiments of the present application, drawings which need to be used in the embodiments will be briefly introduced below. It should be understood that the drawings merely show some embodiments of the present application, and thus should not be considered as limitation to the scope. Those ordinarily skilled in the art still could obtain other relevant drawings according to these drawings, without using any inventive efforts.
FIG. 1 is a structural schematic view of an embodiment of a crystal growth device of the present application; and
FIG. 2 is a diagram of distribution of states of raw materials after a crystal growth finishing step in Example 1 of the present application.

Illustration of reference signs in the drawings
1-crucible portion; 101-first crucible portion; 102-second crucible portion; 1021-concavity; 1022-arc-shaped protrusion; 2-heating portion; 201-first heating portion; 202-second heating portion; 203-third heating portion; 3-seed crystal accommodation portion; 4-raw material accommodation portion; 5-raw-material loading reference plane; 6-upper furnace lid; 7-third electrode; 8-lower furnace lid; 9-first electrode; 10-support column; 11-furnace barrel; 12-second electrode; 13-rotary motor; 14-lifting motor; 15-thermal insulation layer; 16-unreacted-raw-material region.

### DETAILED DESCRIPTION OF EMBODIMENTS

Endpoints and any value of ranges disclosed herein are not limited to the precise ranges or values, and these ranges or values should be understood as encompassing values close to these ranges or values. For numerical ranges, endpoint values of various ranges can be combined with each other, endpoint values of various ranges and individual point values can be combined with each other, and individual point values can be combined with each other to obtain one or more new numerical ranges, and such numerical ranges should be construed as being specifically disclosed herein.

The inventors of the present application have found from researches that during production of a large-size silicon carbide single crystal by the physical vapor transport method, carbon dust is prone to deposit on a crystal growth interface to form defects of inclusions; use of tantalum carbide powder, tantalum microporous bulk or porous graphite may cause problems of greatly increased production costs or deteriorated carbon/silicon element ratio, as well as generation of induced dislocations and even crystal cracks due to excessive internal stress in the silicon carbide single crystal.

In view of this, in the first aspect, the present application provides a growth device of a silicon carbide single crystal. The device includes a crucible portion 1 and a heating portion 2. The crucible portion 1 includes a first crucible portion 101 and a second crucible portion 102 which are coaxially provided from top to bottom. The first crucible portion 101 is provided, in the middle of a top thereof, with a seed crystal accommodation portion 3. The second crucible portion 102 is provided with a cavity which is a raw material accommodation portion 4. An outer diameter of the first crucible portion 101 is smaller than that of the second crucible portion 102. The second crucible portion 102 is provided, in the middle of a bottom thereof, with a concavity 1021 recessed towards the first crucible portion 101.

The heating portion 2 is a graphite heating portion, and the heating portion 2 includes a first heating portion 201, a second heating portion 202 and a third heating portion 203.

The first heating portion 201 is provided in the concavity 1021 in a circumferential direction of the concavity 1021. The second heating portion 202 is provided outside the second crucible portion 102 in a circumferential direction of the second crucible portion 102. The third heating portion 203 is provided outside the first crucible portion 101 in a circumferential direction of the first crucible portion 101. An inner diameter of the third heating portion 203 is smaller than the outer diameter of the second crucible portion 102.

In the present application, the second crucible portion 102 is provided, in the middle of a bottom thereof, with the concavity 1021 recessed towards the first crucible portion 101, the first heating portion 201 is provided in the circumferential direction of the concavity 1021, and the second heating portion 202 is provided outside the second crucible portion 102 in the circumferential direction, so that an upper part of raw materials with a preset thickness in a middle portion of the raw materials may not form a crystallization region and remain in an unreacted state, thus forming an unreacted-raw-material region. Specifically, the first heating portion 201 heats an interior of the raw materials, so as to avoid formation of a crystallization region in the center. As the highest-temperature point of a graphite heater is located in the vicinity of a central height of the heater, through cooperation of the first heating portion 201 and the second heating portion 202, the upper part of raw materials with a preset thickness in the middle portion of the raw materials may be enabled to not react during growth of the silicon carbide single crystal. Further, the outer diameter of the first crucible portion 101 is smaller than that of the second crucible portion 102, the third heating portion 203 is provided outside the first crucible portion 101, and the inner diameter of the third heating portion 203 is smaller than the outer diameter of the second crucible portion 102, so that heat generated by the third heating portion 203 is closer to a central part of an upper surface of the raw materials, and an outer edge of the raw materials is less heated, thus preventing occurrence of carbonization phenomenon at an edge of the raw materials. As the highest-temperature point of the graphite heater is located in the vicinity of the central height of the heater, an upper layer of the raw materials at the edge does not form a severe carbonization region, but instead, an upper part of raw materials with a preset thickness at the edge of the raw materials do not react, and form an unreacted region.

In the present application, the outer diameter of the first crucible portion 101 is smaller than that of the second crucible portion 102, the third heating portion 203 is provided outside the first crucible portion 101, the inner diameter of the third heating portion 203 is smaller than the outer diameter of the second crucible portion 102, the second heating portion 202 is provided outside the second crucible portion 102 in the circumferential direction, the second crucible portion 102 is provided, in the middle of the bottom thereof, with the concavity 1021 recessed towards the first crucible portion 101, and the first heating portion 201 is provided in the circumferential direction of the concavity 1021, so that the upper part of raw materials with a preset thickness of the raw materials do not react and form an unreacted-raw-material region 16. When producing a silicon carbide single crystal by the physical vapor transport method, during sublimation and recrystallization of raw materials, an unreacted region layer can filter carbon dust, prevent the carbon dust from entering a crystal growth chamber, suppress formation of inclusion defects on a crystal growth interface, and inhibit growth of the inclusion defects into a larger range of defects such as screw dislocations, stacking faults and micropipes, thus improving the crystal quality. Besides, after subsequent removal of free carbon and cleaning, the unreacted region can be recycled. Compared with the prior art of filtering the carbon dust using tantalum carbide powder, tantalum microporous bulk, porous graphite and the like, costs can be greatly reduced, and further deterioration of balance of carbon/silicon element ratio to affect the crystal growth can be prevented.

In addition, in the present application, the first heating portion 201 is provided inside the concavity 1021 in the circumferential direction, the second heating portion 202 is provided outside the second crucible portion 102 in the circumferential direction, and the first heating portion 201 and the second heating portion 202 cooperate with each other, so that raw materials at a concavity side and raw materials at a crucible-side-wall side of the second crucible portion 102 are heated more evenly, which can avoid problems of excessive local external temperature, increased carbon dust, local carbon enrichment and carbon collapse caused by external heating alone, and reduce inclusions, screw dislocations, stacking faults, micropipes and like defects in the silicon carbide single crystal. Specifically, the carbon collapse of the raw materials is formed because after sublimation of silicon in the raw materials, carbon skeleton is left, non-uniform temperature causes a gas-phase silicon rich radical to migrate unexpectedly, and react with the carbon skeleton, so that the carbon skeleton disappears, and the upper part of raw materials collapse downwards due to loss of support.

Besides, the outer diameter of the first crucible portion 101 is smaller than that of the second crucible portion 102, the third heating portion 203 is provided outside the first crucible portion 101, and the inner diameter of the third heating portion 203 is smaller than the outer diameter of the second crucible portion 102, so that when the third heating portion 203 heats the top of the second crucible portion 102, and the second heating portion 202 heats the edge, a lower temperature can be used, which can further prevent carbonization of raw materials caused by a higher temperature of the raw materials at the crucible-side-wall side of the second crucible portion 102.

Besides, the outer diameter of the first crucible portion 101 is smaller than that of the second crucible portion 102, and the third heating portion 203 is provided outside the first crucible portion 101, so that during the growth of the silicon carbide single crystal, a radial temperature gradient of the silicon carbide single crystal can be adjusted, thus avoiding the defects of induced dislocations and crystal cracks caused by excessive internal stress, and avoiding edge polycrystalline and polytypism defects caused by a lower temperature at the edge of the crystal.

In the present application, a cross-sectional shape of the seed crystal accommodation portion 3 can be selected in a wide range, and may be polygonal, square, circular, etc., preferably circular. A cross-sectional shape of the concavity 1021 recessed towards the first crucible portion 101 and provided in the middle of the bottom of the second crucible portion 102 can be selected in a wide range, and may be polygonal, square, circular, etc., preferably circular.

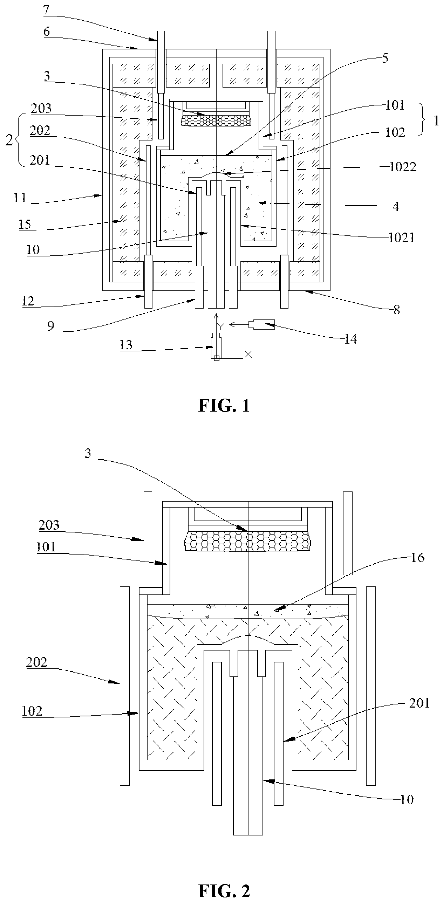

Referring to FIG. 1, the first crucible portion 101 and the second crucible portion 102 of the present application may be in a cylindrical shape. Specifically, an outer diameter of the cylindrical shape of the first crucible portion 101 is smaller than that of the cylindrical shape of the second crucible portion 102. The first crucible portion 101 and the second crucible portion 102 can be formed into stepped cylindrical crucibles communicating with each other. The first crucible portion 101 may be provided, in the middle of the top thereof, with the seed crystal accommodation portion 3 with a circular cross section. The second crucible portion 102 may be provided, in the middle of the bottom thereof, with the concavity 1021 having a circular cross section and recessed towards the first crucible portion 101. The cavity formed by a cylindrical crucible wall of the second crucible portion 102 and the concavity 1021 is provided therein with the raw material accommodation portion 4. The first heating portion 201 may be of a tubular structure with an annular cross section, and the tubular first heating portion 201 with the annular cross section may be provided in the circumferential direction, inside the concavity 1021 with a circular cross section. The second heating portion 202 may be of a tubular structure with an annular cross section, and the tubular second heating portion 202 with the annular cross section may be provided outside the cylindrical second crucible portion 102 in the circumferential direction. The third heating portion 203 may be of a tubular structure with an annular cross section, and the tubular third heating portion 203 with the annular cross section may be provided outside the cylindrical first crucible portion 101 in the circumferential direction.

Optionally, the concavity 1021 is provided, in the middle of a bottom thereof, with an arc-shaped protrusion 1022, and the arc-shaped protrusion 1022 is provided on a side facing the first crucible portion 101. In this solution, it is more conducive to heating the raw materials above the concavity 1021 more uniformly, and avoiding carbonization of raw materials in a high-temperature region and crystallization of raw materials in a low-temperature region.

In the present application, when the cross section of the concavity 1021 is circular, a ratio of a diameter of the arc-shaped protrusion 1022 to a diameter of the bottom of the concavity 1021 may be 0.5-1.0. A ratio of a height of the arc-shaped protrusion 1022 to a distance from a side of the bottom of the concavity 1021 facing the first crucible portion 101 to a raw-material loading reference plane 5 may preferably be 0.15-0.5. Hence, the arc-shaped protrusion 1022 refers to a protrusion whose height gradually decreases from a center of the protrusion to a periphery of the protrusion, where the height of the arc-shaped protrusion 1022 refers to a distance from the side of the bottom of the concavity 1021 facing the first crucible portion 101 to the center of the protrusion, and the raw-material loading reference plane 5 refers to a material plane obtained after the raw materials are loaded into the second crucible portion 102 according to a design amount. In this solution, it is more conducive to heating the raw materials above the concavity 1021 more uniformly, and avoiding carbonization of raw materials in a high-temperature region and crystallization of raw materials in a low-temperature region.

Optionally, a value range of a ratio of the outer diameter of the second crucible portion 102 to the outer diameter of the first crucible portion 101 is 1.05-4.0, a value range of a ratio of the inner diameter of the second heating portion 202 to the inner diameter of the third heating portion 203 is 1.05-4.0, and a value range of a ratio of the diameter of the seed crystal accommodation portion 3 to the inner diameter of the third heating portion 203 is 0.26-0.92. In this solution, the ratio of the outer diameter of the second crucible portion 102 to the outer diameter of the first crucible portion 101 is 1.05-4.0, and the ratio of the inner diameter of the second heating portion 202 to the inner diameter of the third heating portion 203 is 1.05-4.0, so that the heat generated by the third heating portion 203 is closer to the central part of the upper surface of the raw materials, and an outer edge of the raw materials is less heated, thus preventing occurrence of the carbonization phenomenon at an edge of the upper surface of the raw materials, and the unreacted region is formed. Further, the ratio of the diameter of the seed crystal accommodation portion 3 to the inner diameter of the third heating portion 203 is 0.26-0.92, which is more beneficial to adjust the radial temperature gradient of the silicon carbide single crystal, avoid the defects of induced dislocations and crystal cracks caused by excessive internal stress, and avoid edge polycrystalline and polytypism defects caused by a lower temperature at an edge of seed crystals. In this solution, the ratio of the outer diameter of the second crucible portion 102 to the outer diameter of the first crucible portion 101 is not greater than 4, and the ratio of the inner diameter of the second heating portion 202 to the inner diameter of the third heating portion 203 is not greater than 4, which is more beneficial to enable the temperature of the upper layer of raw materials to be more uniform, thereby forming an unreacted region with a uniform thickness, avoiding a small thickness of the unreacted region caused by a high temperature at the edge, and avoiding formation of a crystallization region due to a low temperature in the middle portion; moreover, when producing a large-size silicon carbide single crystal, the structure of the crucible portion thereof is more reasonable. The ratio of the outer diameter of the second crucible portion 102 to the outer diameter of the first crucible portion 101 is not less than 1.05, and the ratio of the inner diameter of the second heating portion 202 to the inner diameter of the third heating portion 203 is not less than 1.05, so that the heat generated by the third heating portion 203 is less transmitted to an outer side portion of the raw materials, thus avoiding a small thickness of the unreacted region caused by a high temperature of the outer side portion, so that the unreacted-raw-material region 16 with a uniform thickness is formed on the whole raw material surface, thereby reducing deposition of carbon dust on the crystal growth surface. The ratio of the diameter of the seed crystal accommodation portion 3 to the inner diameter of the third heating portion 203 is not less than 0.26, which is more beneficial to reduce probability of edge polycrystalline and polytypism of the silicon carbide single crystal.

The ratio of the outer diameter of the second crucible portion 102 to the outer diameter of the first crucible portion 101 specifically may be, for example, 1.1, 1.3, 1.5, 2.0, 3.0 and 4.0. The ratio of the inner diameter of the second heating portion 202 to the inner diameter of the third heating portion 203 specifically may be, for example, 1.1, 1.3, 1.5, 2.0, 3.0 and 4.0. The ratio of the diameter of the seed crystal accommodation portion 3 to the inner diameter of the third heating portion 203 specifically may be, for example, 0.30, 0.40, 0.50, 0.60, 0.70, 0.80 and 0.90.

Optionally, relative to the raw-material loading reference plane 5 of the second crucible portion 102, a position of an upper end of the second heating portion 202 is 10 mm-50 mm higher than a position of the raw-material loading reference plane 5; and a position of a lower end of the second heating portion 202 is 20 mm-100 mm lower than a position of a lower end of the second crucible portion 102. The highest-temperature point of the graphite heater is located in the vicinity of the central height of the heater. In this solution, a top border (upper edge) of the second heating portion 202 is higher than the raw materials, a bottom border (lower edge) of the second heating portion 202 is lower than the raw materials, which is more beneficial to enable an upper temperature, a bottom temperature and a middle temperature of the raw materials to have a small difference, reduce a longitudinal temperature gradient of the raw materials, enable the longitudinal temperature gradient of the raw materials to be more uniform, and avoid severe carbonization of raw materials in a high-temperature region and crystallization of raw materials in a low-temperature region. The distance between the position of the upper end of the second heating portion 202 and the position of the raw-material loading reference plane 5 is restricted to be less than 50 mm, so that it is more beneficial to prevent part of the raw materials close to an outer side of the crucible from being carbonized.

Optionally, a vertical distance between a lower end of the third heating portion 203 and the upper end of the second heating portion 202 is 15 mm-60 mm; and a position of an upper end of the third heating portion 203 is higher than a position of an upper end of a seed crystal accommodation space of the seed crystal accommodation portion 3. An upper furnace lid 6 is provided above the first crucible portion 101, the upper end of the third heating portion 203 is connected to a third electrode 7, and the third electrode 7 is movably connected to the upper furnace lid 6. In this solution, the position of the upper end of the third heating portion 203 is higher than the position of the upper end of the seed crystal accommodation space, which is more beneficial to increase a temperature of an edge of the crystal, suppress formation of polycrystalline and polytypism in case of a large crystal size, avoid extension of polycrystalline and polytypism inwards (i.e., towards an inner circle), increase an area of high-quality crystal, and avoid scrap of a whole crystal. A vertical distance between the lower end of the third heating portion 203 and the upper end of the second heating portion 202 is 15 mm-60 mm, so that the heat generated by the third heating portion 203 is closer to a central part of the upper surface of the raw materials, and the outer edge of the raw materials is less heated, thus preventing occurrence of the carbonization phenomenon at the edge of the surface of the raw materials, which facilitates forming an unreacted region at an edge of the upper layer of the raw materials. The upper furnace lid 6 is provided above the first crucible portion 101, the upper end of the third heating portion 203 is connected to the third electrode 7, and the third electrode 7 is movably connected to the upper furnace lid 6, which is more conducive to disassembling and assembling a heat field, and is more beneficial to avoid non-uniform temperature around the crystal caused by heat generation of the electrode.

Optionally, a lower furnace lid 8 is provided below the second crucible portion 102, a lower end of the first heating portion 201 is connected to a first electrode 9, and the first electrode 9 is movably connected to the lower furnace lid 8. The concavity 1021 is connected to a support column 10 in the middle of the bottom thereof, the support column 10 is connected to a side facing back to the first crucible portion 101, the first heating portion 201 is provided to be spaced apart from the support column 10, the bottom of the concavity 1021 and a side surface of the concavity 1021 respectively, at an interval of 15 mm-40 mm. In this solution, the lower furnace lid 8 is provided below the second crucible portion 102, the lower end of the first heating portion 201 is connected to the first electrode 9, and the first electrode 9 is movably connected to the lower furnace lid 8, which is more conducive to disassembling and assembling a heat field, and is more beneficial to avoid non-uniform temperature around the bottom of the raw materials caused by heat generation of the electrode. The first heating portion 201 is provided to be spaced apart from the support column 10, the bottom of the concavity 1021 and the side surface of the concavity 1021 respectively, at an interval of 15 mm-40 mm, which is more conducive to avoiding ignition of the first heating portion 201 and the support column 10 or the concavity 1021 caused by conductive carbon powder and silicon powder escaping from graphite components, raw materials, etc.

Optionally, the first electrode 9 is movably connected to the lower furnace lid 8, and the third electrode 7 is movably connected to the upper furnace lid 6, the lower end of the second heating portion 202 is connected to the second electrode 12, and the second electrode 12 is movably connected to the lower furnace lid 8. By making the electrodes to be movably connected to the furnace lids, in this solution, positions of the first heating portion 201, the second heating portion 202 and the third heating portion 203 may be finely adjusted, and by finely adjusting the position of the heating portion 2, it is more conducive to enabling part of the raw materials with a uniform thickness on the surface of the raw materials to not react.

Optionally, a lower end of the support column 10 is connected to a rotary motor 13 and a lifting motor 14. By the rotary motor 13 driving the crucible portion 1 to rotate, it is more conducive to compensating for uneven distribution of temperature of the raw materials in the circumferential direction. A longitudinal position of the crucible portion 1 may be finely adjusted by the lifting motor 14, which is more conducive to finely adjusting the longitudinal temperature gradient of the raw materials, and finely adjusting the radial temperature gradient of the raw materials in conjunction with a power ratio of the first heating portion 201 to the second heating portion 202.

Optionally, a thermal insulation layer 15 is provided above the first crucible portion 101, below the second crucible portion 102, and around the second heating portion 202 and the third heating portion 203.

In the second aspect, the present application provides a growth method of a silicon carbide single crystal using the growth device in the first aspect, where powers of the first heating portion 201, the second heating portion 202 and the third heating portion 203 are P1, P2 and P3 respectively, and the crystal growth method includes steps as follows.

Heating-up step: raw materials are loaded into a raw material accommodation portion 4, and seed crystals are mounted and fixed in a seed crystal accommodation portion 3; air tightness in a furnace shell cavity enclosed by an upper furnace lid 6, a lower furnace lid 8 and a furnace barrel 11 is detected, and then a vacuumizing treatment is performed on interior of the furnace shell cavity; and the first heating portion 201, the second heating portion 202 and the third heating portion 203 perform heating, so as to enable a temperature of a top of the first crucible portion 101 to reach 2,100-2,200 °C, where during the heating, relationships between P1, P2 and P3 are as follows: P1 < P3 < P2, P2 > P1 + P3, and P1: P3 = 0.1-0.5.

Crystal growth step: first adjustment, second adjustment, third adjustment and fourth adjustment are performed in sequence. The first adjustment is to adjust a ratio of P1 to P2, to enable a temperature difference between raw materials at the crucible-side-wall side of the second crucible portion 102 and raw materials at the concavity 1021 side to be less than 15 °C. The second adjustment is to adjust P3 so as to adjust a ratio of P3 to P1+P2, to enable a temperature of an upper surface of the raw materials to be 15 °C-80 °C higher than a temperature of a lower surface of the seed crystals. The third adjustment is to adjust P3, so as to enable a temperature difference between seed crystals at the edge and seed crystals in the middle to be less than 20 °C. The fourth adjustment is to adjust a pressure in the furnace shell cavity to be 50 Pa-1,500 Pa, so that radicals volatized from the raw materials crystallize and grow on a surface of the seed crystals, and an upper part of raw materials with a preset thickness of the raw materials do not react.

Crystal growth finishing step: fifth adjustment, sixth adjustment and seventh adjustment are performed in sequence. The fifth adjustment is to increase the pressure in the furnace shell cavity to 2,500 Pa-20,000 Pa. The sixth adjustment is to adjust P1+P2 downwards to reduce an axial temperature gradient of the silicon carbide single crystal, so that the axial temperature gradient between a lower surface of the silicon carbide single crystal and an upper surface of the silicon carbide single crystal is ≤ 20 °C/cm. The seventh adjustment is to slowly lower P1, P2 and P3 to enable P1 = P2 = P3 = 0. In the above, the sixth adjustment and the seventh adjustment are separated by a preset period of 2 h or above.

In the present application, the lower surface of the silicon carbide single crystal refers to a surface close to the second crucible portion 102, and the upper surface of the silicon carbide single crystal refers to a surface facing back to the second crucible portion 102.

In the present application, in the heating-up step, powers of the first heating portion 201, the second heating portion 202 and the third heating portion 203 are defined. In a crystal growth stage, the first adjustment, the second adjustment, the third adjustment and the fourth adjustment are performed in sequence, which is more conducive to enabling the upper part of raw materials with a uniform thickness of the raw materials not to react. In a crystal growth finishing stage, after the pressure in the furnace shell cavity is increased to 2,500-20,000 Pa, P1+P2 is first adjusted downwards, to reduce the axial temperature gradient between the lower surface of the silicon carbide single crystal and the upper surface of the silicon carbide single crystal, P1, P2 and P3 are kept constant, and in situ annealing is performed, which is more conducive to reducing internal stress of the crystal.

**Specifically,** in the heating-up step, by enabling P1 < P3 < P2, P1 is the smallest, and P2 is the largest, which is more beneficial to avoid a too high temperature in a central region and central over-temperature possibly brought about in processes of adjusting the powers, rotating the crucibles, and lifting and lowering the crucibles. Further, P2 > P1 + P3 is enabled, and three heaters are adjusted within respective controllable ranges, which is more beneficial to control formation of a temperature gradient in the furnace, more beneficial to form a uniform unreacted region on the surface of materials. Further, P1: P3 = 0.1-0.5, which is more beneficial to enable the upper part of raw materials with a preset thickness in the middle portion of the raw materials not to react.

Specifically, by performing the first adjustment first to adjust the ratio of P1 to P2, then performing the second adjustment to adjust P3 so as to adjust the ratio of P3 to P1 + P2, where (P1 + P2) determines a temperature of a lower part, and P3 determines a temperature of an upper part, after the ratio of P1 to P2 is adjusted, (P1 + P2) can be regarded as one variable, and the longitudinal temperature gradient can be achieved just by adjusting the ratio of (P1 + P2) to P3.

Specifically, in a crystal growth finishing stage, the pressure in the furnace shell cavity is increased to 2,500-20,000 Pa, which is more beneficial to rapidly reduce a volatilization speed of the raw materials and suppress further growth of crystals. P1 + P2 is first adjusted downwards, so as to reduce the axial temperature gradient between the lower surface of the silicon carbide single crystal and the upper surface of the silicon carbide single crystal. P1, P2 and P3 are kept constant, and by keeping P1, P2 and P3 constant, it is more beneficial to reduce crystal stress.

Optionally, ninth adjustment is further included between the third adjustment and the fourth adjustment. The ninth adjustment is to finely adjust the position of the second crucible portion (102) by the lifting motor, so that the temperature of the lower part of the raw materials is higher than the temperature of the upper part of the raw materials, and a temperature difference is controlled to be within 15 °C, which is more conducive to promoting volatilization of the silicon carbide raw materials.

Optionally, the vacuumizing treatment includes, in sequence, vacuumizing by a mechanical pump to enable the pressure in the furnace shell cavity to be 0.1 Pa-5 Pa, vacuumizing by a molecular pump to enable the pressure in the furnace shell cavity to be 10⁻² Pa-10⁻⁴ Pa, and heating by the first heating portion 201, the second heating portion 202 and the third heating portion 203 to enable a temperature of the top of the first crucible portion 101 to reach 750 °C-850 °C. In this solution, by vacuumizing by the mechanical pump, vacuumizing by the molecular pump and heating by three heating portions in sequence, the temperature of the top of the first crucible portion 101 is enabled to reach 750 °C-850 °C, which is more beneficial to remove oxygen and moisture in the furnace shell cavity as well as moisture adsorbed by various components, thus avoiding oxidation of the raw materials and heat field materials.

Optionally, the heating-up step further includes, when the temperature of the top of the first crucible portion 101 reaches 900-1,100 °C, adjusting and maintaining the pressure in the furnace shell cavity to be 10,000 Pa-20,000 Pa. In this solution, when the temperature of the top of the first crucible portion reaches 900-1,100 °C, after the pressure is raised, the temperature is further raised to 2,100-2,200 °C, so as to avoid the radicals volatized from the raw materials from starting to be deposited on the seed crystals before the temperature reaches a temperature suitable for the growth of the single crystal, which is more conducive to improving the quality of the crystal growth.

Optionally, eighth adjustment is further included after the fourth adjustment. The eighth adjustment includes: in the case that the ratio of P1 to P2 is constant, P1+P2 is adjusted upwards, so that the temperature difference between the upper surface of the raw materials and the lower surface of the silicon carbide single crystal is increased at a rate of 0.5 °C/h-5.0 °C/h, so that the temperature of the upper surface of the raw materials is 30 °C-100 °C higher than that of the lower surface of the silicon carbide single crystal. Volatilization of the raw materials in reaction is continuous. In this solution, volatilization of remaining raw materials may be accelerated by gradually increasing the temperature, so that a sublimation speed of the raw materials may not be rapidly decreased because of prolonged growth duration of the crystal, and a relatively stable growth rate of the crystal is maintained, which is more beneficial to improve the crystal quality.

### Example 1:

With reference to FIG. 1, a growth device of a silicon carbide single crystal of the present example included a crucible portion 1 and a heating portion 2. The crucible portion 1 included a first crucible portion 101 and a second crucible portion 102 which were cylindrical and coaxially provided from top to bottom. A bottom of the first crucible portion 101 communicated with a top of the second crucible portion 102. A ratio of an outer diameter of the second crucible portion 102 to an outer diameter of the first crucible portion 101 was 1.5. The first crucible portion 101 was provided, in the middle of a top thereof, with a seed crystal accommodation portion 3 having a circular cross section. The second crucible portion 102 was provided, in the middle of a bottom thereof, with a concavity 1021 having a circular cross section and recessed towards the first crucible portion 101. A ratio of a depth of the concavity 1021 to a distance from a raw-material loading reference plane 5 to the bottom of the second crucible portion 102 was 0.85. A ratio of a diameter of the concavity 1021 to an outer diameter of the second crucible portion 102 was 0.45. An arc-shaped protrusion 1022 was provided in the middle of a side of the bottom of the concavity 1021 facing the first crucible portion 101. A ratio of a diameter of the arc-shaped protrusion 1022 to a diameter of the bottom of the concavity was 0.9. A ratio of a height of the arc-shaped protrusion 1022 to a distance from the side of the bottom of the concavity 1021 facing the first crucible portion 101 to the raw-material loading reference plane 5 was 0.5. A cavity formed by a cylindrical crucible wall of the second crucible portion 102 and the concavity 1021 was a raw material accommodation portion 4. A support column 10 was connected to the middle of one side of the bottom of the concavity 1021 facing back to the first crucible portion 101. A lower end of the support column 10 was connected to a rotary motor 13 and a lifting motor 14. A first heating portion 201 with an annular cross section was provided inside the concavity 1021 in a circumferential direction. The first heating portion 201 was spaced apart from the support column 10, the bottom of the concavity 1021 and a side surface of the concavity 1021 by 20 mm, respectively. A second heating portion 202 with an annular cross section was provided outside the second crucible portion 102 in a circumferential direction. A third heating portion 203 with an annular cross section was provided outside the first crucible portion 101 in a circumferential direction. A ratio of an outer diameter of the second crucible portion 102 to an inner diameter of the third heating portion 203 was 1.2. A ratio of an inner diameter of the second heating portion 202 to that of the third heating portion was 1.3. A ratio of a diameter of the seed crystal accommodation portion to the inner diameter of the third heating portion was 0.6. Relative to the raw-material loading reference plane 5 of the second crucible portion 102, a position of an upper end of the second heating portion 202 was 25 mm higher than a position of the raw-material loading reference plane 5, and a position of a lower end of the second heating portion 202 was 50 mm lower than a position of a lower end of the second crucible portion 102. A vertical distance between a lower end of the third heating portion 203 and the upper end of the second heating portion 202 was 40 mm. A position of an upper end of the third heating portion 203 was 100 mm higher than a position of an upper end of an accommodation space of the seed crystal accommodation portion 3. An upper furnace lid 6 was provided above the first crucible portion 101. A lower furnace lid 8 was provided below the second crucible portion 102. A lower end of the first heating portion 201 was connected to a first electrode 9. The lower end of the second heating portion 202 was connected to a second electrode 12. The upper end of the third heating portion 203 was connected to a third electrode 7. The first electrode 9 and the second electrode 12 were movably connected to the lower furnace lid 8. The third electrode 7 was movably connected to the upper furnace lid 6.

A growth method of a silicon carbide single crystal included: a heating-up step: after a heat field structure was mounted, raw materials were loaded into the raw material accommodation portion 4 until the raw-material loading reference plane 5. Seed crystals were mounted and fixed in the seed crystal accommodation portion 3. Air tightness in a furnace shell cavity enclosed by the upper furnace lid 6, the lower furnace lid 8 and a furnace barrel 11 was detected, and then the furnace shell cavity was vacuumized by a mechanical pump to enable a pressure therein to be 0.1 Pa-5 Pa, and the furnace shell cavity was further vacuumized by a molecular pump until the pressure therein was 10⁻² Pa-10⁻⁴ Pa. The rotary motor 13 was turned on, and heating was performed by the first heating portion 201, the second heating portion 202 and the third heating portion 203 to enable a temperature of the top of the first crucible portion 101 to reach 800 °C. After that, a mixed gas including nitrogen/hydrogen gas and inert gas was charged into the furnace shell cavity. When the temperature of the top of the first crucible portion 101 reached 1,000 °C, the pressure in the furnace shell cavity was adjusted and maintained within a range of 10,000-20,000 Pa, such that the temperature of the top of the first crucible portion 101 was raised to 2,100-2,200 °C. In the heating-up step, power P1 of the first heating portion 201, power P2 of the second heating portion 202, and power P3 of the third heating portion 203 were kept to satisfy: P1 < P3 < P2, P2 < P1 + P3 and P1: P3 = 0.3.

Crystal growth step: first adjustment was performed to adjust P1/P2, to enable a temperature difference between raw materials at the crucible-side-wall side of the second crucible portion 102 and raw materials at the concavity 1021 side to be less than 10 °C. Second adjustment was performed to adjust P3 so as to adjust P3/P1+P2, to enable a temperature of an upper surface of the raw materials to be 15 °C-80 °C higher than a temperature of a lower surface of the seed crystals. The third adjustment was performed to adjust P3, to enable a temperature difference between seed crystals at the edge and seed crystals in the middle to be less than 10 °C, and to detect a temperature difference between the upper surface of the raw materials and the lower surface of the seed crystals. Ninth adjustment was performed to finely adjust a position of the crucible portion 1 by the lifting motor 14, so that a temperature of a lower part of the raw materials was higher than temperature of an upper part of the raw materials by less than 15 °C. Fourth adjustment was performed to slowly lower the pressure in the furnace shell cavity, so that the pressure in the furnace shell cavity was kept at 50 Pa-1,500 Pa. Eighth adjustment was performed, where in the case that the ratio of P1 to P2 was constant, P1+P2 were adjusted upwards, so that the temperature difference between the upper surface of the raw materials and the lower surface of the silicon carbide single crystal was increased at a rate of 0.5 °C/h-5.0 °C/h, such that the temperature of the upper surface of the raw materials was 30-100 °C higher than that of the lower surface of the silicon carbide single crystal.

Crystal growth finishing step: fifth adjustment was performed to increase the pressure in the furnace shell cavity to 2,500-20,000 Pa. Sixth adjustment was performed to adjust P1+P2 downwards, such that an axial temperature gradient between the lower surface of the silicon carbide single crystal and the upper surface of the silicon carbide single crystal was less than 20 °C/cm, which was maintained for 3 h. Seventh adjustment was performed to lower P1, P2 and P3 and enable P1 = P2 = P3 = 0.

### Example 2

It was carried out according to Example 1, but was different in that the side of the bottom of the concavity 1021 facing the first crucible portion 101 was not provided with the arc-shaped protrusion 1022.

### Example 3

It was carried out according to Example 1, but was different in that: the ratio of the outer diameter of the second crucible portion 102 to that of the first crucible portion 101 was 1.02, the ratio of the inner diameter of the second heating portion 202 to that of the third heating portion 203 was 1.02, and the ratio of the outer diameter of the second crucible portion 102 to the inner diameter of the third heating portion 203 was 1.01.

### Example 4

It was carried out according to Example 1, but was different in that: the ratio of the outer diameter of the second crucible portion 102 to that of the first crucible portion 101 was 4.2, the ratio of the inner diameter of the second heating portion 202 to that of the third heating portion 203 was 4.2, and the ratio of the outer diameter of the second crucible portion 102 to the inner diameter of the third heating portion 203 was 4.

### Example 5

It was carried out according to Example 1, but was different in that the ratio of the diameter of the seed crystal accommodation portion 3 to the inner diameter of the third heating portion 203 was 0.24.

### Example 6

It was carried out according to Example 1, but was different in that: relative to the raw-material loading reference plane 5 of the second crucible portion 102, the position of the upper end of the second heating portion 202 was 5 mm higher than the position of the raw-material loading reference plane 5, and the position of the lower end of the second heating portion 202 was 5 mm lower than the position of the lower end of the second crucible portion 102.

### Example 7

It was carried out according to Example 1, but was different in that the vertical distance between the lower end of the third heating portion 203 and the upper end of the second heating portion 202 was 10 mm.

### Comparative Example 1

It was carried out according to Example 1, but was different in that: the second crucible portion 102 was not provided, in the middle of the bottom thereof, with the concavity 1021 having a circular cross section and recessed towards the first crucible portion 101, and the first heating portion 201 was not provided; in the growth method of a silicon carbide single crystal, in the heating-up step, the heating was performed by the second heating portion 202 and the third heating portion 203, the power P2 of the second heating portion 202 and the power P3 of the third heating portion 203 satisfied P3 < P2; in the crystal growth step, the first adjustment was not performed, the second adjustment was to adjust P3 so as to adjust P3/P2, and the eighth adjustment was to adjust P2 upwards; and in the crystal growth finishing step, the sixth adjustment was to adjust P2 downwards, and the same was maintained for 3 h.

### Comparative Example 2

It was carried out according to Example 1, but was different in that: the outer diameter of the first crucible portion and the outer diameter of the second crucible portion were consistent, the inner diameter of the second heating portion and the inner diameter of the third heating portion were consistent, and the ratio of the outer diameter of the second crucible portion 102 to the inner diameter of the third heating portion 203 was 0.95.

Edge polycrystalline and polytypism, inclusions, dislocation densities and micropipes of the silicon carbide single crystals of Examples 1-7 and Comparative Examples 1-2 were detected, and specific detection methods were as follows: observing the polycrystalline and polytypism with naked eyes under white light, or observing the polytypism with naked eyes under illumination of an ultraviolet lamp; observing surfaces of polished crystals with a microscope, to detect the number of inclusions; after etching surfaces of wafers, observing shapes and number of corrosion pits with a microscope, and detecting dislocation densities and the number of micropipes of the wafers; and judging whether the raw materials reacted according to surface colors of the raw materials in Examples 1-7 and Comparative Examples 1-2, and judging whether the raw materials crystallized according to whether the raw materials were agglomerated and whether new crystals were generated on the surface of the raw materials. Detection results are shown in TABLE 1. Morphological distribution of the raw materials after the crystal growth finishing step in Examples 1-7 and Comparative Examples 1-2 was detected. A detection method for the morphological distribution of the raw materials included observing appearance color and shape of the raw materials with eyes.

**TABLE 1 [98]**

| Item | Silicon Carbide Single Crystal | | | | Morphology of raw material |
|---|---|---|---|---|---|
| | Cumulative area of inclusion | Dislocation density /cm² | Micropipe /cm² | Edge polycrystalline and polytypis m | |
| Example 1 | ≤0.05% | ≤3000 | ≤0.2 | None | A layer of loose unreacted raw materials on upper surface, and loose carbonized raw materials below |
| Example 2 | ≤0.05% | ≤4000 | ≤0.2 | None | Loose unreacted raw materials on upper surface except a thin layer of agglomeration in the center, and loose carbonized raw materials below |
| Example 3 | ≤2% | ≤6000 | ≤0.5 | More | No agglomeration in centers of upper and lower surfaces, and a small amount of carbonization at edge |
| Example 4 | ≤0.05% | ≤6000 | ≤1.0 | Small amount | No agglomeration in centers of upper and lower surfaces, and immeasurable carbonization at edge, but a small amount of agglomeration in a position of about half diameter of the upper surface of raw materials |
| Example 5 | ≤0.1% | ≤7000 | ≤0.5 | More | No agglomeration in centers of upper and lower surfaces, and immeasurable carbonization at edge |
| Example 6 | ≤0.05% | ≤5000 | ≤0.5 | Almost none | No agglomeration in centers, and agglomeration at edges of upper and lower surfaces |
| Example 7 | ≤1% | ≤5000 | ≤0.5 | Less | No agglomeration in centers of upper and lower surfaces, and carbonization at edge |
| Comparativ e Example 1 | ≤0.5% | ≤6000 | ≤2.0 | Small amount | Agglomeration of raw materials with axis as center to form a spindle shape, and slight carbonization of outer side of raw materials |
| Comparativ e Example 2 | ≤2.5% | ≤8000 | ≤2.0 | Severe | No agglomeration in centers of upper and lower surfaces, and more carbonization at edge |

Lattices in the vicinity of inclusions were distorted, which will further increase probability of occurrence of dislocations and micropipes. By comparing Examples 1-7 with Comparative Examples 1-2, with reasonable design of relative positions and sizes of the heating portions and the crucible portions, in cooperation with a reasonable process, during the crystal growth, there was always a layer of raw materials, on the surface of the raw materials, which did not participate in reaction, which can prevent the carbon dust below from floating with air flow to the crystal growth surface to form inclusions, reduce densities of dislocations and micropipes, and improve the internal quality of the crystal. By controlling relative diameters of the seed crystal accommodation portion and the third heating portion, a crystal without ppolycrystalline and polytypism at edge can be more easily obtained.

Preferred embodiments of the present application are described in detail in the above, but the present application is not limited thereto. Within the scope of technical concept of the present application, various simple modifications can be made to the technical solutions of the present application, including combination of various technical features in any other suitable manners, and these simple modifications and combinations should likewise be considered as contents disclosed in the present application, and all belong to the scope of protection of the present application.

### INDUSTRIAL APPLICABILITY

The growth device of a silicon carbide single crystal provided in the present application overcomes the defects of inclusions, screw dislocations, stacking faults and micropipes existing in the silicon carbide single crystals manufactured by the PVT method, as well as the defects of generation of induced dislocations and even crystal cracks in the silicon carbide single crystals due to excessive internal stress, and can effectively reduce the defects of inclusions, screw dislocations, stacking faults, micropipes, etc. in the silicon carbide single crystals, and reduce the internal stress.

The growth method of a silicon carbide single crystal provided in the present application can enable the upper part of raw materials with a preset thickness of the raw materials not to react, where the unreacted raw materials, as a filter layer, can prevent the carbon dust from entering a crystal growth chamber, so as to reduce the defects such as inclusions, screw dislocations, stacking faults and micropipes in the silicon carbide single crystal, and after the crystal growth is finished, the unreacted raw materials can be recycled after removal of free carbon and cleaning.

## Claims

1. A growth device of a silicon carbide single crystal, wherein the device comprises a crucible portion (1) and a heating portion (2), **characterized in that**:
the crucible portion (1) comprises a first crucible portion (101) and a second crucible portion (102) which are coaxially provided from top to bottom, a seed crystal accommodation portion (3) is provided in a middle of a top of the first crucible portion (101), the second crucible portion (102) is provided with a cavity which is a raw material accommodation portion (4), an outer diameter of the first crucible portion (101) is smaller than an outer diameter of the second crucible portion (102), and a concavity (1021) recessed towards the first crucible portion (101) is provided in a middle of a bottom of the second crucible portion (102);
the heating portion (2) is a graphite heating portion, and the heating portion (2) comprises a first heating portion (201), a second heating portion (202) and a third heating portion (203); and
the first heating portion (201) is provided in the concavity (1021) in a circumferential direction of the concavity (1021), the second heating portion (202) is provided outside the second crucible portion (102) in a circumferential direction of the second crucible portion (102), the third heating portion (203) is provided outside the first crucible portion (101) in a circumferential direction of the first crucible portion (101), and an inner diameter of the third heating portion (203) is smaller than the outer diameter of the second crucible portion (102).

2. The growth device according to claim 1, wherein an arc-shaped protrusion (1022) is provided in a middle of a bottom of the concavity (1021), and the arc-shaped protrusion (1022) is provided on a side facing the first crucible portion (101).

3. The growth device according to claim 1, wherein a value range of a ratio of the outer diameter of the second crucible portion (102) to the outer diameter of the first crucible portion (101) is 1.05-4.0, a value range of a ratio of the inner diameter of the second heating portion (202) to the inner diameter of the third heating portion (203) is 1.05-4.0, and a value range of a ratio of the diameter of the seed crystal accommodation portion (3) to the inner diameter of the third heating portion (203) is 0.26-0.92.

4. The growth device according to claim 1, wherein relative to a raw-material loading reference plane (5) of the second crucible portion (102), a position of an upper end of the second heating portion (202) is 10 mm-50 mm higher than a position of the raw-material loading reference plane (5); and a position of a lower end of the second heating portion (202) is 20 mm-100 mm lower than a position of a lower end of the second crucible portion (102).

5. The growth device according to claim 4, wherein a vertical distance between a lower end of the third heating portion (203) and the upper end of the second heating portion (202) is 15 mm-60 mm; and
a position of an upper end of the third heating portion (203) is higher than a position of an upper end of a seed crystal accommodation space of the seed crystal accommodation portion (3), an upper furnace lid (6) is provided above the first crucible portion (101), the upper end of the third heating portion (203) is connected to a third electrode (7), and the third electrode (7) is movably connected to the upper furnace lid (6).

6. The growth device according to claim 1, wherein a lower furnace lid (8) is provided below the second crucible portion (102), a lower end of the first heating portion (201) is connected to a first electrode (9), and the first electrode (9) is movably connected to the lower furnace lid (8); and
the concavity (1021) is connected to a support column (10) in the middle of a bottom of the concavity, the support column (10) is connected to a side facing back to the first crucible portion (101), and the first heating portion (201) is provided to be spaced apart from the support column (10), the bottom of the concavity (1021) and a side surface of the concavity (1021) respectively, at an interval of 15 mm-40 mm.

7. The growth device according to claim 1, wherein the seed crystal accommodation portion (3) has a circular cross section.

8. The growth device according to claim 1, wherein the first crucible portion (101) and the second crucible portion (102) are cylindrical.

9. The growth device according to claim 2, wherein when a cross section of the concavity (1021) is circular, a ratio of a diameter of the arc-shaped protrusion (1022) to a diameter of a bottom of the concavity (1021) is 0.5-1.0, and a ratio of a height of the arc-shaped protrusion (1022) to a distance from a side of the bottom of the concavity (1021) facing the first crucible portion (101) to a raw-material loading reference plane (5) is 0.15-0.5.

10. The growth device according to claim 6, wherein a lower end of the support column (10) is connected to a rotary motor (13) and a lifting motor (14).

11. The growth device according to claim 1, wherein a thermal insulation layer (15) is provided above the first crucible portion (101), below the second crucible portion (102), and around the second heating portion (202) and the third heating portion (203).

12. A growth method of a silicon carbide single crystal using the growth device according to any one of claims 1 to 11, wherein powers of the first heating portion (201), the second heating portion (202) and the third heating portion (203) are P1, P2 and P3 respectively, and the growth method comprises steps as follows:
a heating-up step: loading raw materials into a raw material accommodation portion (4), and mounting and fixing seed crystals in the seed crystal accommodation portion (3); detecting air tightness in a furnace shell cavity enclosed by an upper furnace lid (6), a lower furnace lid (8) and a furnace barrel 11, and then performing vacuumizing treatment on interior of the furnace shell cavity; and heating by the first heating portion (201), the second heating portion (202) and the third heating portion (203), so as to enable a temperature of a top of the first crucible portion (101) to reach 2,100 °C-2,200 °C, wherein during the heating, relationships between P1, P2 and P3 are: P1 < P3 < P2, P2 > P1 + P3, and P1: P3 = 0.1-0.5;
a crystal growth step: performing first adjustment, second adjustment, third adjustment and fourth adjustment in sequence, wherein the first adjustment comprises adjusting a ratio of P1 to P2, to enable a temperature difference between raw materials at a crucible-side-wall side of the second crucible portion (102) and raw materials at a concavity (1021) side to be less than 15 °C; the second adjustment comprises adjusting P3 so as to adjust a ratio of P3 to P1+P2, to enable a temperature of an upper surface of the raw materials to be 15 °C-80 °C higher than a temperature of a lower surface of the seed crystals; the third adjustment comprises adjusting P3, so as to enable a temperature difference between the seed crystals at an edge and the seed crystals in a middle to be less than 20 °C; the fourth adjustment comprises adjusting a pressure in the furnace shell cavity to be 50 Pa-1,500 Pa, so that radicals volatized from the raw materials crystallize and grow on a surface of the seed crystals, and an upper part of raw materials with a preset thickness of the raw materials do not react; and
a crystal growth finishing step: performing fifth adjustment, sixth adjustment and seventh adjustment in sequence, wherein the fifth adjustment comprises increasing the pressure in the furnace shell cavity to 2,500-20,000 Pa; the sixth adjustment comprises adjusting P1+P2 downwards to reduce an axial temperature gradient of the silicon carbide single crystal, so that the axial temperature gradient between a lower surface of the silicon carbide single crystal and an upper surface of the silicon carbide single crystal is ≤ 20 °C/cm; and the seventh adjustment comprises lowering P1, P2 and P3, to enable P1 = P2 = P3 = 0, wherein the sixth adjustment and the seventh adjustment are separated by a preset period, wherein the preset period is 2 h or above.

13. The growth method according to claim 12, wherein the vacuumizing treatment comprises, in sequence, vacuumizing by a mechanical pump to enable the pressure in the furnace shell cavity to be 0.1 Pa-5 Pa, vacuumizing by a molecular pump to enable the pressure in the furnace shell cavity to be 10⁻²-10⁻⁴ Pa, and heating by the first heating portion (201), the second heating portion (202) and the third heating portion (203) to enable a temperature of the top of the first crucible portion (101) to reach 750-850 °C.

14. The growth method according to claim 12, wherein the heating-up step further comprises adjusting and maintaining the pressure in the furnace shell cavity to be 10,000 Pa-20,000 Pa, when the temperature of the top of the first crucible portion (101) reaches 900-1,100 °C.

15. The growth method according to claim 12, wherein eighth adjustment is further comprised after the fourth adjustment, wherein the eighth adjustment comprises: in a case that the ratio of P1 to P2 is constant, adjusting P1+P2 upwards, so that the temperature difference between the upper surface of the raw materials and the lower surface of the silicon carbide single crystal is increased at a rate of 0.5 °C/h-5.0 °C/h, and that the temperature of the upper surface of the raw materials is 30 °C-100 °C higher than the temperature of the lower surface of the silicon carbide single crystal.

16. The growth method according to claim 12, wherein ninth adjustment is further comprised between the third adjustment and the fourth adjustment, wherein the ninth adjustment comprises adjusting a position of the second crucible portion (102) by a lifting motor, so that a temperature of a lower part of the raw materials is higher than a temperature of an upper part of the raw materials, and a temperature difference is controlled to be within 15 °C.
